# EUROPEAN PATENT SPECIFICATION

(11) **EP 2 410 570 B1**
(45) Date of publication and mention of the grant of the patent: **27.01.2016**
(21) Application number: 10753732.6
(22) Date of filing: 19.03.2010
(51) Int. Cl.: H01L 31/048, C08J 7/04

(54) **SOLAR CELL BACK SHEET INCLUDING A FLUORINE-BASED COPOLYMER, AND METHOD FOR MANUFACTURING SAME**
RÜCKSEITIGE FOLIE FÜR SOLARZELLE ENTHALTEND EIN COPOLYMER AUF FLUORBASIS UND VERFAHREN ZUR HERSTELLUNG DERSELBEN
FEUILLE ARRIÈRE POUR CELLULE SOLAIRE COMPRENANT UN COPOLYMÈRE À BASE DE FLUOR ET PROCÉDÉ DE FABRICATION DE CELLE-CI

(30) Priority: 19.03.2009 KR 20090023633
(43) Date of publication of application: 25.01.2012
(73) Proprietor: LG Chem, Ltd., Youngdungpo-gu Seoul 150-721 (KR)
(72) Inventor: KIM, Hyun-Cheol, Daejeon 305-707 (KR); KWON, Yoon-Kyung, Daejeon 305-340 (KR); KO, Hyun-Seong, Seoul 158-822 (KR)
(74) Representative: Goddar, Heinz J.
(86) International application number: PCT/KR2010/001723
(87) International publication number: WO 2010/107282

(56) References cited:
- WO-A1-2010/101810
- JP-A- 2001 068 695
- JP-A- 2001 111 077
- JP-A- 2007 103 738
- JP-A- 2008 181 929
- JP-A- 2009 038 236
- US-A1- 2007 154 704
- US-A1- 2007 166 469

## Description

### BACKGROUND

### 1. Field of the Invention

The present invention relates to a solar cell back sheet including a fluorine-based copolymer and a method of manufacturing the same, and, more particularly, to a solar cell back sheet for protecting the back side of a solar cell, which has excellent physical properties, such as heat resistance, weather resistance, electrical characteristics, etc., which is hardly constricted by heat, which can reduce manufacturing cost, and which has high productivity, and a method of manufacturing the same.

### 2. Discussion of Related Art

Recently, because of the earth's environment problems, fossil fuel exhaustion and the like, new reproductive energy sources have attracted considerable attention. Among these new reproductive energy sources, solar cells, which are nonpolluting energy sources, have been being actively researched and developed.

A solar cell, which applies a solar power generating principle, is a semiconductor device for converting solar energy into electricity. A solar cell is made of a monocrystalline, polycrystalline or amorphous silicon semiconductor, and has a basic structure similar to a diode.

Since a solar cell must be exposed to an external environment for a long period of time in order to easily absorb solar light, it is manufactured in the form of a unit by conducting various packaging processes that protect solar cells. Such a unit is referred to a solar cell module.

Generally, as a sheet used to package solar cells, a back sheet having excellent weatherability and durability is used such that a solar cell is reliably protected even when it is exposed to the external environment four 20 years or more.

Such a back sheet is fabricated by forming a resin layer having weatherability and durability on one side of a substrate layer.

Generally, the resin layer having weatherability and durability is made of a fluorine-based resin. However, the fluorine-based resin is problematic in that it has insufficient adhesivity to the substrate layer, and in that it needs high drying temperature when it is formed into a fluorine-based resin solution and then applied onto the substrate layer.

In this case, since the fluorine-based resin solution requiring high drying temperature is dried using an expensive drying apparatus for providing high drying temperature, the production cost of a solar cell back sheet increases. Further, since the high drying temperature causes the thermal deformation of the substrate layer, the productivity and quality of a solar cell module decrease.

US 2007154704 discloses fluoropolymer coated films comprising a polymeric substrate film and a fluoropolymeric coating on the polymeric substrate film.

US 2007166469 discloses a liquid fluoropolymer coating composition and a process for using the composition to make fluoropolymer coated polymeric substrates.

Therefore, it is required to develop a solar cell back sheet which has excellent durability and weatherability, which can be dried at low temperature, which can reduce the production cost thereof and which can improve the productivity and quality of a solar cell module.

### SUMMARY OF THE INVENTION

Accordingly, the present invention has been devised to solve the above-mentioned problems, and an object of the present invention is to provide a solar cell back sheet which has excellent durability and weatherability, which is dried at low temperature, which can reduce the production cost thereof and which can improve the productivity and quality of a solar cell module.

These problems underling the present invention have been solved by a solar cell back-sheet, a method of manufacturing thereof and a solar cell according to the independent claims. Preferred embodiments result from the sub-claims.

In order to accomplish the above object, an aspect of the present invention provides a solar cell back sheet, including: a substrate layer; and a resin layer, wherein the resin layer is formed on at least one side of the substrate layer, and includes a polyvinylidene fluoride (PVDF)-based polymer having a crystallinity of 10 to 40%.

The polyvinylidene fluoride (PVDF)-based copolymer has a comonomer content of 5 to 50 wt%, which may be selected from the group consisting of hexafluoropropylene (HFP), chlorotrifluoroethylene (CTFE), tetrafluoroethylene (TFE), trifluoroethylene, hexafluoroisobutylene, perfluorobutyl ethylene, perfluoropropylvinyl ether (PPVE), perfluoroethylvinyl ether (PEVE), perfluoromethylvinyl ether (PMVE), perfluoro-2,2-dimethyl-1,3-dioxolan (PDD), and perfluoro-2-methylene-4-melhyl-1,3-dioxolan (PMD).

Another aspect of the present invention provides a method of manufacturing the solar cell back, including the steps of: providing a substrate layer; dissolving a resin material containing a polyvinylidene fluoride (PVDF)-based polymer having a crystallinity of 10 to 40% in a solvent having a boiling point of 200 °C or lower to prepare a coating solution; and applying the coating solution onto at least one side of the substrate layer and then drying the applied coating solution at a temperature of 250 °C or lower to form a resin layer.

Still another aspect of the present invention provides a solar cell including the solar cell back sheet.

According to the present invention, the productivity and quality of a solar cell back sheet can be improved, and the production costs of a solar cell back sheet and a solar cell module can be greatly reduced.

### BRIEF DESCRIPTION OF THE DRAWINGS

FIG. 1 is a sectional view of a solar cell back sheet according to an embodiment of the present invention.
FIG. 2 is a sectional view of a solar cell back sheet according to another embodiment of the present invention.
FIG. 3 is a schematic view showing the structure of a solar cell according to an embodiment of the present invention.
FIG. 4 is a graph showing the results of measuring the crystallinity of a polymer of Example 1 according to the present invention.
FIG. 5 is a graph showing the results of measuring the crystallinity of a polymer of Example 2 according to the present invention.
FIG. 6 is a graph showing the results of measuring the crystallinity of a polymer of Example 4 according to the present invention.
FIG. 7 is a graph showing the results of measuring the crystallinity of a polymer of Example 5 according to the present invention.
FIG. 8 is a graph showing the results of measuring the crystallinity of a polymer of Comparative Example 1,
FIG. 9 is sectional views of solar cell back sheets of the present invention and a conventional solar cell back sheet.

### DETAILED DESCRIPTION OF EXEMPLARY EMBODIMENTS

Hereinafter, the present invention will be described in detail.

A solar cell back sheet according to an embodiment of the present invention includes: 1) a substrate layer; and 2) a resin layer, wherein the resin layer is formed on at least one side of the substrate layer, and includes a polyvinylidene fluoride (PVDF)-based polymer having a crystallinity of 10 to 40%.

In the present invention, the crystallinity means the percentage of a crystal region existing in a polymer. That is, the crystallinity is defined as the percentage of a crystal region to a non-crystal region in a polymer. Generally, the solubility of a polymer in a solvent decreases as the crystallinity of a polymer increases.

In the present invention, the crystallinity of the polyvinylidene fluoride (PVDF)-based polymer is 10 to 40%.

Although polyvinylidene fluoride (PVDF) has excellent physical properties, such as durability, weatherability, etc., it has a regular element arrangement, so that its crystallinity is relatively high, with the result that its solubility in a solvent is not good. Therefore, the polyvinylidene fluoride-based polymer of the present invention is converted into a polyvinylidene fluoride-based copolymer having low crystallinity by polymerizing polyvinylidene fluoride with a comonomer to remove the regular element arrangement

In order to improve the solubility of the polyvinylidene fluoride-based polymer in a solvent to such a degree that it is sufficiently dissolved in the solvent, it is preferred that this polyvinylidene fluoride-based polymer have a crystallinity of 10 to 40%. When the crystallinity of the polyvinylidene fluoride-based polymer is more than 50%, it is difficult to dissolve a sufficient amount of polyvinylidene fluoride-based polymer in a solvent.

Since a copolymer having excessively low crystallinity is difficult to be manufactured, and its physical properties are deteriorated, it is preferred that a copolymer having a crystallinity of 10 to 40% be used in consideration of solubility, ease of manufacture and physical properties.

A fluorine-based polymer, which has been largely used to improve the weatherability, of a conventional solar cell back sheet, is characterized in that it does not easily dissolve in a solvent having a low boiling point. However, the polyvinylidene fluoride (FVDF)-based polymer having a crystallinity of 10 to 40% can exhibit excellent durability and weatherability, and can be dissolved in a solvent having a low boiling point of 200 °C or lower, preferably 160°C or lower. Therefore, when this polyvinylidene fluoride (PVDF)-based polymer is included in a resin layer of a solar cell back sheet, the resin layer can be dried at low temperature during the process of manufacturing the solar cell back sheet. For this reason, the thermal deformation of a substrate layer can be minimized, the production cost of a solar cell module can be reduced, and the productivity and quality of a solar cell module can be improved.

Further, when the resin layer is formed using the polyvinylidene fluoride (PVDF)-based polymer having a crystallinity of 10 to 40%, the adhesivity between the resin layer and the substrate layer can be improved even when the chemical bond between the functional group of the resin layer and the functional group of the substrate layer is not formed. Concretely, during the process of manufacturing the solar cell back sheet, the polyvinylidene fluoride (PVDF)-based polymer having a crystallinity of 10 to 40% can be diffused into the substrate layer or an additional layer, such as a primer layer, formed on the substrate layer at the interface between the resin layer and the substrate layer or the interface between the resin layer and the additional layer formed on the substrate layer. For this reason, the adhesion between the resin layer and the substrate layer or the adhesion between the resin layer and the additional layer can be physically improved. In addition, chemical interactions, such as van der Waal's bonds, hydrogen bonds, ionic bonds, covalent bonds, etc., can be generated by the functional groups included in the polyvinylidene fluoride (PVDF)-based polymer, and thus the adhesion between the resin layer and the substrate layer can be additionally improved.

In the present invention, the polyvinylidene fluoride (PVDF)-based polymer having a crystallinity of 10 to 40% may have a weight-average molecular weight of 50,000 to 1,000,000. When the weight-average molecular weight thereof is more than 1,000,000, there is a problem in that solubility is lowered. Further, when the weight-average molecular weight thereof is less than 50,000, there is a problem in that the physical properties of film are deteriorated.

In the present invention, the polyvinylidene fluoride (PVDF)-based polymer having a crystallinity of 10 to 40% may have a melting point of 80 °C to 175 °C, and preferably 120 °C to 165 °C. When the melting point thereof is higher than 175 °C, there is a problem in that the solubility of the polymer in a solvent is flowered or the gloss of the coated surface of a film is deteriorated. Further, when the melting point thereof is lower than 80 °C, there is a problem in that a solar cell back sheet may be deformed during a process of manufacturing a solar cell module.

In the present invention, a polyvinylidene fluoride (PVDF)-based copolymer having a comonomer content of 5 to 50 wt% is used as the polyvinylidene fluoride (PVDF)-based polymer.

Examples of the comonomer may include, but are not limited to, hexafluoropropylene (HFP), chlorotrifluoroethylene (CTFE), tetrafluoroethylene (TFE), trifluoroethylene, hexafluoroisobutylene, perfluorobutyl ethylene, perfluoropropylvinyl ether (PPVE), perfluoroethylvinyl ether (PEVE), perfluoromethylvinyl ether (PMVE), perfluoro-2,2-dimethyl-1,3-dioxolan (PDD), and perfluoro-2-methylene-4-methyl-1,3-dioxolan (PMD).

The amount of the comonomer is not particularly limited as long as the amount thereof ranges between 5 to 50 wt% based on the total amount of the polyvinylidene fluoride (PVDF)-based copolymer. However, in order to exhibit the durability and weatherability necessary for a solar cell back sheet and simultaneously exhibit the desired low-temperature, drying characteristics, the amount thereof may be 7 to 40 wt%, preferably 10 to 30 wt%, and more preferably 10 to 20 wt%.

In order to improve the adhesion between the resin layer and the substrate layer and to reduce the production cost of a solar cell back sheet, the resin layer may further include at least one of methyl methacrylate (MMA) and glycidyl methacrylate (GMA), each of which is an acrylic polymer having excellent compatibility with a polyvinylidene fluoride-based copolymer, as an additive. Further, in order to further improve the adhesion between the resin layer and the substrate layer, the resin layer may further include a polymer including at least one selected from the group consisting of methylmethacrylate (MMA), glycidylmethacrylate (GMA), hydroxyethylmethacrylate (HEMA) and cyclohexylmaleimide (CHMI). For example, the resin layer may further include at least one selected from the group consisting of polymethylmethacrylate (PMMA), a copolymer of methylmethacrylate and glycidylmethacrylate (MMA-GMA), a ternary copolymer of methylmethacrylate, glycidylmethacrylate and hydroxyethylmethacrylate (MMA-GMA-HEMA), and a copolymer of methylmethaclylate and cyclohexylmaleimide (MMA -CHMI).

In the case where the additive is used, the amount of the additive may be 50 wt% or less, and preferably 3 to 30 wt%. When the amount of the additive is more than 50 wt%, there is a problem in that the weatherability of the resin layer is deteriorated.

This acrylic additive is effective in that the adhesion between the resin layer and the substrate layer is increased by the interaction between the acrylic additive and an acrylic primer of a primer layer for forming the resin layer. That is, the acrylic additive is diffused into the primer layer, thus providing physical bonding force between the resin layer and the primer layer. Further, when the acrylic additive has a functional group, such as an epoxy group, a hydroxy group, a carboxyl group or the like, chemical bonding force can be additionally provided between the resin layer and the primer layer, thus further increasing the bonding force between the resin layer and the primer layer.

In addition to the acrylic additive, methacrylic acid (MAA), acrylic acid (AA) or the like may be additionally used.

In an embodiment of the present invention, when the resin layer includes the polyvinylidene fluoride (PVDF)-based copolymer and polymethylmethacrylate (PMMA), it is preferred that the weight ratio thereof be 10∼6 : 0∼4. Further, when the resin layer includes the polyvinylidene fluoride (PVDF)-based copolymer and a copolymer of methylmethacrylate and cyclohexylmaleimide (MMA-CHMI), it is preferred that the weight ratio thereof be 10∼7 : 0∼3. Further, when the resin layer includes the polyvinylidene fluoride (PVDF)-based copolymer and a copolymer of methylmethacrylate and glycidylmethacrylate (MMA-GMA), it is preferred that the weight ratio thereof be 10∼7 : 0∼3. Further, when the resin layer includes the polyvinylidène fluoride (PVDF)-based copolymer, polymethylmethacrylate (PMMA) and a copolymer of methylmethacrylate and glycidylmethacrylate (MMA-GMA), it is preferred that the weight ratio thereof be 10∼6 ; 0∼2 : 0∼2. Further, when the resin layer includes the polyvinylidene fluoride (PVDF)-based copolymer, polymethylmethacrylate (PMMA) and a copolymer of methylmethacrylate and cyclohexylmaleimide (MMA-CHMI), it is preferred that the weight ratio thereof be 10∼6 : 0∼2 : 0∼2. Furthermore, when the resin layer includes the polyvinylidene fluoride (PVDF)-based copolymer, polymethylmethacrylate (PMMA) and a copolymer of methylmethacrylate and glycidylmethacrylate (MMA-GMA), it is preferred that the weight ratio thereof be 10∼6 :0∼2 : 0∼2.

It is preferred that the glycidylmethacrylate (GMA) and cyclohexylmaleimide (MMA-CHMI) be not each independently used, but be used in the form of a copolymer of methylmethacrylate and glycidylmethacrylate (MMA-GMA) and a copolymer of methylmethacrylate and cyclohexylmaleimide (MMA-CHMI). In addition to these copolymers, additives, such as a copolymer of methylmethacrylate and hydroxyethylmethacrylate (MMA-HEMA), a copolymer of methylmethacrylate and acylic acid (MMA-AA), a copolymer of methylmethacrylate and methacylic acid (MMA-MAA) and the like, may be used.

Further, the resin layer may further include a pigment and/or a filler in order to improve the power generation efficiency of a solar cell and to improve the physical properties of a solar cell back sheet.

Examples of the pigment and/or filler may include carbon black; metal oxides, such as chromium oxide (Cr₂O₃), iron oxides (Fe₂O₃, Fe₃O₄), etc.; complex metal oxides; metal salts; and various kinds of organic pigments. Further, example of white pigments may include titanium dioxide (TiO₂), barium sulfate (BaSO₄), barium titanate (BaTiO₃), strontium titanate (SrTiO₃), calcium titanate (CaTiO₃), calcium carbonate, lead titanate (PbTiO₃), zinc oxide, zinc sulfide, magnesium oxide (MgO), aluminum oxide (Al₂O₃), silica (SiO₂), zirconia (ZrO₂), and the like.

The kind of the pigment which can be used for a solar cell back sheet is not particularly limited, but, if possible, it is preferred that a pigment having excellent weatherability be selected because the pigment is exposed to the outside for a long period of time. For example, a pigment, such as a dye, the color change of which is caused by the destruction of double bonds thereof, or a pigment, such as titanium dioxide having a photocatalytic function, which is yellowed by the destruction of polymer chains therearound, may not be used.

Since the photocatalytic function of titanium dioxide becomes active as its particle size decreases, it is preferred for the sake of dispersity and reflectance that the titanium dioxide that is used has a particle size of 0.2 µm or more. Particularly, since titanium dioxide having a particle size of less than 0.2 µm exhibits low reflectance in a long-wavelength region (about 800 nm), it is not effective in terms of the external quantum efficiency of a crystalline silicon solar cell.

Since the reflectance of white light of the pigment becomes higher or the transmittance of black light of the pigment becomes lower as the dispersity of the pigment is improved, if possible, it is preferable to increase the dispersity of the pigment. In order to improve the dispersity of the pigment, it is preferred that surface-treated pigment be selectively used or a wettable pigment dispersant be used.

The pigment may be dispersed using a high-speed mixer or using ball milling or micromilling.

Further, the resin layer may be formed by coating one side or both sides of the substrate layer with a coating solution in which the above-mentioned polyvinylidene fluoride-based copolymer and, if necessary, the above-mentioned additive are dissolved in a solvent having a relatively low boiling point. In this case, the substrate layer may be coated with the coating solution using various methods, such as comma, comma reverse, slot die, lip die, gravure, reverse gravure, and the like. When both sides of the substrate layer with the coating solution, the coating process may be conducted sequentially or simultaneously.

Preferably, the resin layer may be formed by applying a coating solution prepared by dissolving a resin material containing the polyvinylidene fluoride (PVDF)-based copolymer in a solvent having a boiling point of 200°C or lower, preferably, 160°C or lower onto the substrate layer. For example, the solvent may be selected from the group consisting of, but are not limited to, acetone, methyl ethyl ketone (MEK), dimethylformamide (DMF), dimethylacetamide (DMAC), and mixtures thereof.

The solvent selected from the group consisting of methyl ethyl ketone (MEK), dimethylformamide (DMF), and dimethylacetamide (DMAC) is volatilized at a temperature of 160°C or lower, can easily dissolve the resin material containing the polyvinylidene fluoride (PVDF)-based polymer having a crystallinity of 10 to 40%, and can be dried at relatively low temperature after it was applied onto the substrate layer together with the polyvinylidene fluoride (PVDF)-based copolymer. Further, since this solvent partially dissolves a substrate layer or a primer layer formed on the substrate layer, the components of the resin layer are mixed with the components of the substrate layer at the interface between the resin layer and the substrate layer, thus improving the physical bonding force between the resin layer and the substrate layer.

In the present invention, when the resin material containing the polyvinylidene fluoride (PVDF)-based copolymer having a crystallinity of 10 to 40% is mixed with the above-mentioned additive, it is preferred that a mixed solvent of a solvent having high solubility of the

polyvinylidene fluoride (PVDF)-based copolymer having a crystallinity of 10 to 40% and a solvent having high solubility of the additive be used as the solvent. As described above, when the mixed solvent is used, the mixing ratio of the mixed solvent is proportional to the mixing ratio of the polyvinylidene fluoride (PVDF)-based copolymer and the additive. A specific example of the mixed solution may be, but is not limited to, a mixed solvent of methyl ethyl ketone (MEK) and dimethylformamide (DMF).

Further, a solvent that can suitably swell the substrate layer or an additional layer, such as a primer layer formed on the substrate layer, as well as the polyvinylidene fluoride (PVDF)-based copolymer having a crystallinity of 10 to 40% or a mixed solvent of a solvent that can dissolve the polyvinylidene fluoride (PVDF)-based copolymer having a crystallinity of 10 to 40% and a solvent that can swell the substrate layer or an additional layer, such as a primer layer formed on the substrate layer, may be used as the solvent, thereby further improving the bonding force between the substrate layer and the resin layer.

In the formation of the resin layer, drying may be conducted by those skilled in the art at a temperature of 250°C or lower for a predetermined amount of time. In the present invention, the drying temperature may be 200 °C or lower, preferably 100 °C to 180°C, and more preferably 100 °C to 160 °C . The drying time may be 1 to 30 minutes and preferably 3 to 10 minutes.

When the drying temperature is higher than 250°C there is a problem in that the high-temperature drying equipment must be used, so that the production cost thereof increases and thermal deformation of the substrate layer is caused, thereby remarkably deteriorating the productivity and quality of a solar cell back sheet.

The resin layer may have a thickness of 5 to 100 micrometers, and preferably 10 to 30 micrometers. When the thickness of the resin layer is below 5 micrometers, the resin layer is excessively thin, so that it is not sufficiently charged with a filler, thereby deteriorating light shielding properties. When the thickness thereof is above 100 micrometers, the unit cost of production thereof is increased by the waste of raw materials.

The substrate layer may be made of various kinds of materials according to the function, use and the like necessary for a solar cell back sheet. For example, the substrate layer may be made of a metal material, a resin material, a glass fiber, a nonwoven fabric or the like. In this case, it is preferred that a polyester-based resin layer be used as the resin layer. Concretely, the resin layer may be formed of, but is not limited to, polyethylene terephthalate (PET), polyethylene naphthalate (PEN), polybutylene terephthalate (PBT) or the like, preferably polyethylene terephthalate (PET).

The substrate layer may have a thickness of 50 to 500 micrometers, and preferably 100 to 300 micrometers. When the thickness of the substrate layer is below 50 micrometers, the resin layer cannot sufficiently exhibit electric insulation properties, water blocking properties and mechanical properties. When the thickness thereof is above 500 micrometers, the substrate layer is difficult to treat, and the unit cost of production thereof is increased.

The solar cell back sheet may further include a primer layer between the substrate layer and the resin layer, the primer layer serving to improve adhesion between the substrate layer and the resin layer.

The primer layer may be formed on the surface of the substrate layer prior to the formation of the resin layer. It is preferred that the primer layer be made of a compound having a functional group for improving the adhesion between the primer layer and the resin layer.

Concretely, the primer layer may be made of at least one selected from the group consisting of polyamine, polyamide, amorphous acrylamide, polyethyleneimine, an ethylene copolymer or ethylene ternary copolymer, polyolefin maleate, an acrylate or methacrylate polymer, polyester, a polyurethane epoxy polymer, and an epoxy acrylic oligomer.

The solar cell back sheet may further include variously-functional layers in addition to the substrate layer and the resin layer. Preferably, the solar cell back sheet may further include an adhesive layer and/or an insulation layer in addition to the substrate layer and the resin layer. For example, the solar cell back sheet may be a multi-layered solar cell back sheet in which a resin layer is formed on one side of a substrate layer, and an adhesive layer and an insulation layer are sequentially formed on the other side of the substrate layer. The insulation layer may be formed of a material commonly known in the art, for example, an ethylene-vinyl acetate (EVA) layer. The ethylene-vinyl acetate (EVA) layer functions as an insulation layer, has high adhesivity to an encapsulation film, can reduce the production cost thereof, and can improve reworkability.

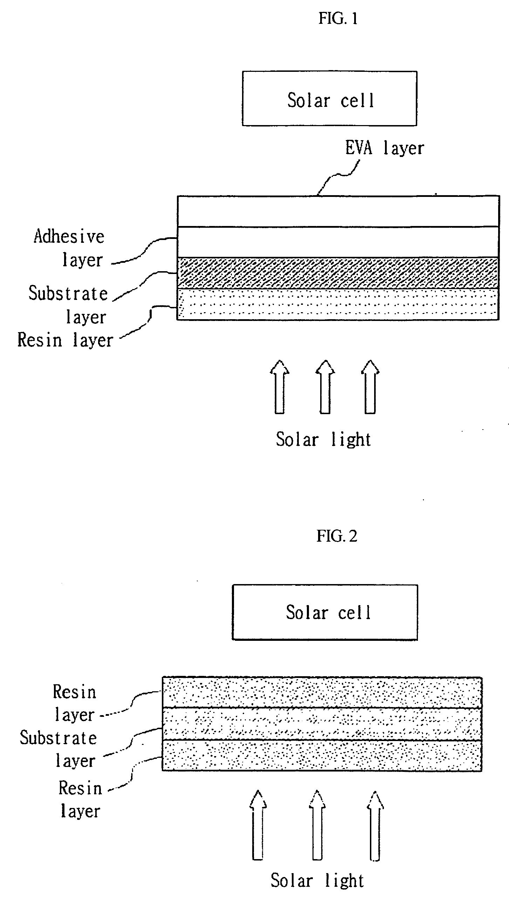

FIG. 1 is a sectional view of a solar cell back sheet according to an embodiment of the present invention, and FIG. 2 is a sectional view of a solar cell back sheet according to another embodiment of the present invention. However, the scope of the present invention is not limited to these drawings.

Referring to FIG. 1, a solar cell back sheet has a structure in which a resin layer, a substrate layer, an adhesive layer and an ethylene vinyl acetate (EVA) layer are sequentially layered. Here, the EVA layer, which is an insulation layer, is disposed in a direction facing a solar cell, and the resin layer is disposed in a direction directly facing solar light while being exposed to the external environment.

Further, referring to FIG. 2, a solar cell back sheet may have a structure in which resin layers are formed on both sides of a substrate layer. In this case, each of the resin layers functions as an ethylene vinyl acetate (EVA) layer for imparting insulation properties and workability to the solar cell back sheet.

This multilayered solar cell back sheet is advantageous in terms of insulation to a solar cell, durability and weatherability to external environment, workability, productivity, production cost reduction, and the like.

Further, the present invention provides a method of manufacturing a solar cell back sheet, including the steps of: 1) providing a substrate layer; 2) dissolving a resin material containing a polyvinylidene fluoride (PVDF)-based polymer having a crystallinity of 10 to 40% in a solvent having a boiling point of 200 °C or lower to prepare a coating solution; and 3) applying the coating solution onto at least one side of the substrate layer and then drying the applied coating solution at a temperature of 250 °C or lower to form a resin layer.

In the method of manufacturing a solar cell back sheet according to the present invention, the resin layer is dried at 250 °C or lower, preferably 200 °C or lower, more preferably 100°C to 180°C, and further more preferably 100°C to 160°C to manufacture a solar cell back sheet exhibiting weatherability, and durability. Therefore, this method is advantageous in that the productivity and quality of a solar cell back sheet can be improved and the production cost thereof can be reduced by minimizing the thermal deformation of a solar cell back sheet, particularly, a substrate layer.

In the method of manufacturing a solar cell back sheet according to the present invention, since the amount and kind of the copolymer, the kind of the substrate layer and the resin layer, the additional comonomer and primer layer, and the like are as above, a detailed description thereof will be omitted.

In the case of a fluorine film, the film formed by casting is slightly thermally-constricted compared to the film formed by extrusion, but, in the process of applying an adhesive onto a polyester film, process temperature cannot be increased to a predetermined temperature or higher. Therefore, the thermal constriction characteristics of a solar cell back sheet are not greatly improved.

In a process of forming a fluorine film into plywood using an adhesive, coating defects may occur during an adhesive application process, pinholes may occur during a fluorine film forming process, and wrinkles may occur during a process of rolling or unrolling the formed fluorine film. Therefore, this process has high defect occurrence frequency compared to the coating process of the present invention, and requires a post-curing process conducted at room temperature ∼ 60 °C for 4 ∼ 7 days after the process of forming a fluorine firm into plywood. Therefore, there is a problem in that this post-curing process needs a lot of time compared to the coating process.

In the coating process, although pinholes may occur during a procedure of applying a fluorine resin, when process temperature is higher than the melting point of the fluorine resin, the pinholes are removed due to the melting of the fluorine resin, and the fluorine resin is applied beneath the polyester film, so that the process of rolling or unrolling the fluorine film is not required, and thus wrinkles does not occur. Further, since the fluorine resin is not a reactive resin, the post-curing process is not required.

A solution process is advantageous compared to a melting process such as an extruding process in terms of dispersity of a pigment. In the case of the extruding process, although it is not easy to uniformly disperse a pigment in the molten high-viscosity resin, the viscosity thereof can be adjusted by the solvent of the present invention, so mat a large amount of pigment can be added in the melting process, the dispersity of pigment can be further increased, thus increasing the cell efficiency thereof.

In the case of a crystalline solar cell, in order to increase the cell efficiency thereon, it is advantageous in that the reflectance of a solar cell back sheet is high. In the case of a thin-film solar cell, it is advantageous in that the transmittance of a solar cell back sheet is low because the thin-film solar cell is characterized in that the cell efficiency thereof is increased as the inner temperature thereof is increased due to its high thermal absorptivity. When the dispersity of a pigment is improved, it is advantageous in that the reflectance of white light is increased or the transmittance of black light is decreased, and in that the UV shielding effect of the solar cell in a wavelength of 400 nm or less can be increased higher as the dispersity of the pigment is increased.

Further, the present invention provides a solar cell including the solar cell back sheet.

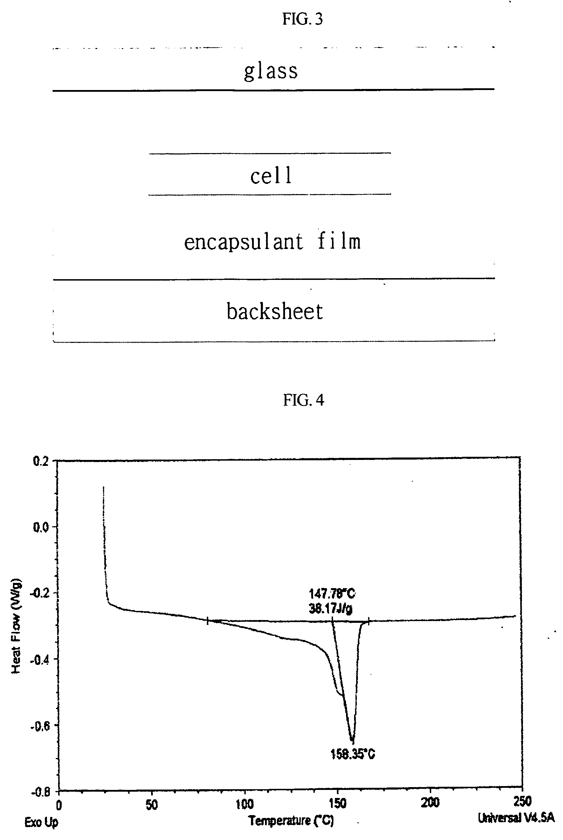

The solar cell according to the present invention may be configured such that a filler made of thermosetting plastic (ethylene-vinyl acetate copolymer) is charged around unit cells disposed in series or in parallel to each other, a glass plate is disposed on the surface of the solar cell colliding with solar light, and the back side of the solar cell is protected by the solar cell back sheet of the present invention. FIG. 3 is a sectional view showing a solar cell module according to the present invention.

This solar cell may be manufactured by methods commonly known in the related field, except that it includes the solar cell back sheet of the present invention.

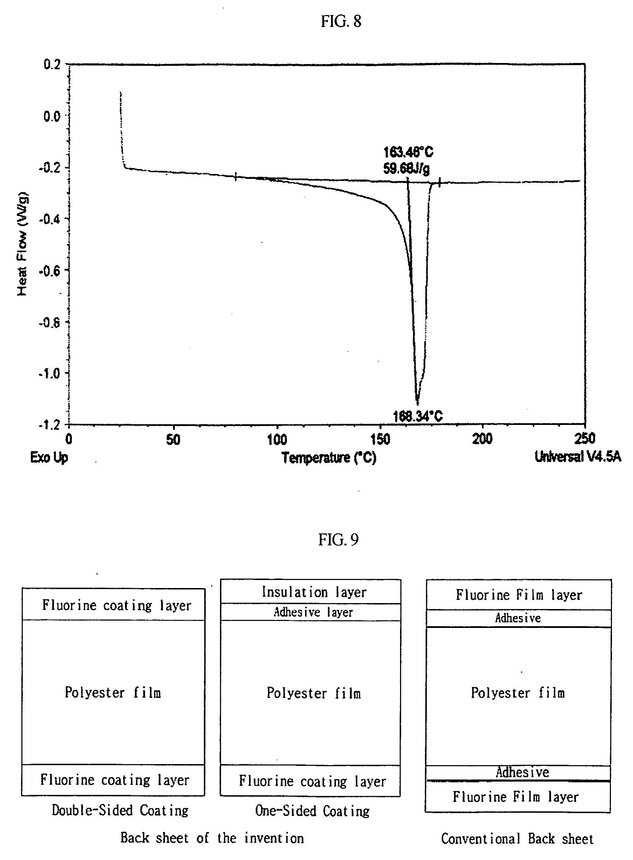

FIG. 9 is sectional views of solar cell back sheets of the present invention and a conventional solar cell back sheet.

Referring to FIG. 9, the conventional solar cell back sheet is manufactured by forming adhesive layers on both sides of a polyester film and then attaching a fluorine resin film prepared by extrusion or casting to each of the adhesive layers. However, since the solar cell back sheet of the present invention is manufactured by directly forming a fluorine resin film on a polyester film through a coating process, it can be easily manufactured, and the fluorine resin film can include a large amount of high-dispersion pigment because it can be formed by dispersing the pigment in a coating solution.

Hereinafter, the present invention will be described in more detail with reference to the following Examples. However, these Examples are merely set forth to illustrate the present invention, and the scope of the present invention is not limited thereto.

### <Example>

Polyvinylidene fluoride-based copolymers (PVDF-HFP copolymers and (PVDF-CTFE copolymers) of Examples 1 to 5, each including hexafluoropropylene (HFP) or chlorotrifluoroethylene (CTEF) as a comonomer in the content ratio given in Table 1, and a polyvinylidene fluoride-based homopolymer of Comparative Example 1 were provided, respectively.

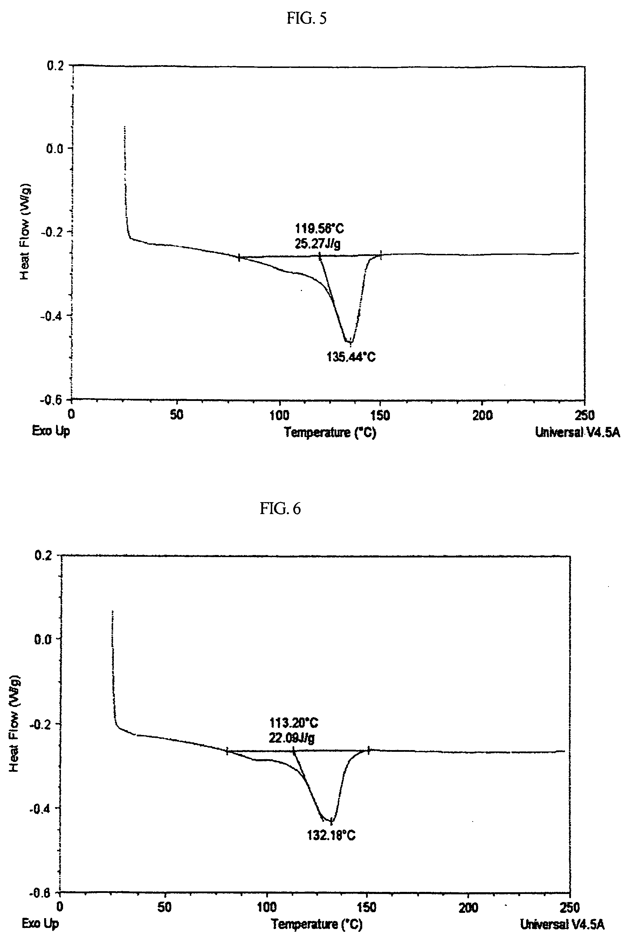

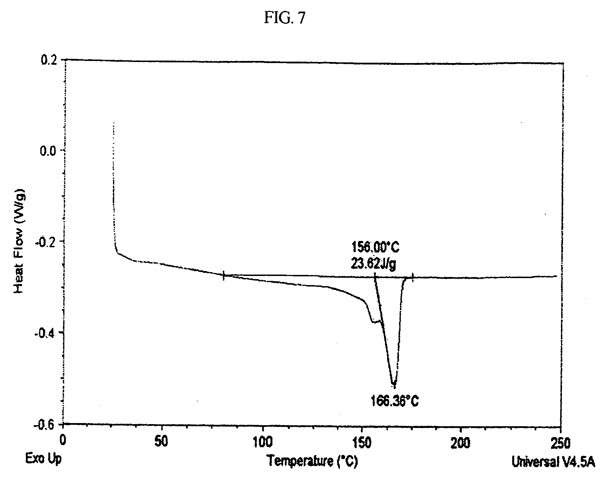

The crystallinity of each of the polymers was measured using a differential scanning calorimeter (DSC). The heat of fusion (ΔHf) occurring when the polymers were secondarily heated was measured, and, in this case, the rate of heating was 10 K/min. The heat of fusion (ΔHf) is obtained by measuring the area between 80°C and the temperature higher than the melting point by 3 °C. Since the heat of fusion (ΔHf) of 100% crystalline PVDF was 105 J/g, the crystallinity of each of the polymers was calculated based on this value. The crystallinity of each copolymer was also calculated based on the heat of fusion (ΔHf) of 100% crystalline PVDF. The results of measuring the crystallinity of each of the polymers of Examples 1 to 5 and Comparative Example 1 are shown in FIGS. 4 to 8.

**[Table 1]**

| | Kind ofpolymer | Crystallinity | Weight-overage molecular weight (Mw) | Melting point |
|---|---|---|---|---|
| Ex.1 | PVDF-HFP copolymer (PVEF 90wt%+HFP 10wt%) | 36% | 320,000 | 158 |
| Ex. 2 | PVDF-HFP copolymer (PVEF 88wt% + HFP 12wt%) | 24% | 330,000 | 135 |
| Ex. 3 | PVDF-HFP copolymer (PVEF 85w1%+HFP 15wt%) | 22% | 240,000 | 132 |
| Ex. 4 | PVDF-HFP copolymer (PVEF 85wt% + HFP 15wt%) | 21% | 300,000 | 132 |
| Ex. 5 | PVDF-HFP copolymer (PVEF 85wt% + CTFE 15wt%) | 23% | 590,000 | 166 |
| Comp. Ex. 1 | PVDF homopolymer | 56∼61% | 270,000 | 169 |

### Test Example 1

The maximum amounts of the polymers of Comparative Example 1 and Examples 1 and 3 which can be dissolved in various solvents without gel formation were measured, and the results thereof are given in Table 2 below.

**[Table 2]**

| Solvent (boiling point, °C) | Comparative Example 1 | Examples 1 | Example 3 |
|---|---|---|---|
| Acetone (57) | 0 | 15 | 520* |
| THF (65) | <10 | - | 500* |
| MEK (80) | <10 | <10 | 430* |
| DMF (153) | 200* | 220* | 440* |
| DMAC (166) | 200* | 210* | 250* |
| Acetone/THF (1/1 Vol) | <10 | - | 480* |
| THF/DMAC(1/1 Vol) | 230* | - | - |
| DMAC/MEK (38/62 Vol) | 260* | 270* | - |

| | | | |
|---|---|---|---|
| "*" represents each of the maximum amounts of the polymers which can be introduced into a solvent | | | |

The unit of each of the amounts of the polymers is wt%.

Referring to Table 2, it can be ascertained that the solubility of each of the PVDF copolymers having low crystallinity in solvents having a low boiling point is higher than that of the PVDP homopolymer of Comparative Example 1. For reference, in the case of "-", test data does not exist.

### Test Example 2

The solubility of each of the polymers of Comparative Example 1 and Examples 1 to 5 in various solvents, when 100g of the polymer were respectively dissolved in 100g of various solvents, was measured, and the results thereof are given in Table 3 below.

**[Table 3]**

| Solvent | Boiling point (°C) | Comp. Ex. 1 | Ex. 1 | Ex. 2 | Ex. 3 | Ex. 4 | Ex. 5 | PMMA |
|---|---|---|---|---|---|---|---|---|
| Acetone | 57 | X | X | ⊚ | ⊚ | ⊚ | - | ⊚ |
| THF | 65 | X | X | Δ | Δ | Δ | - | ⊚ |
| MEK | 80 | X | X | Δ | ⊚ | ⊚ | - | ⊚ |
| DMF | 153 | ○ | ⊚ | ⊚ | ⊚ | ⊚ | ⊚ | Δ |
| DMAC | 166 | ○ | ⊚ | ⊚ | ⊚ | ⊚ | ⊚ | ○ |

| | | | | | | | | |
|---|---|---|---|---|---|---|---|---|
| ⊚ Excellent ○: Good Δ: Soluble -: Partially soluble X: Insoluble PMMA: polymethylmethacrylate | | | | | | | | |

Referring to Table 3, it can be ascertained that the solubility of each of the polymers of Examples 1 to 5 is high with respect to solvents having a low boiling point as well as solvents having a high boiling point

### Test Example 3

The homopolymer of Comparative Example 1 and the copolymers of Example 1,2 and 5 and a solvent (solvent in which MEK and DMF are mixed at a ratio of 3:1) were respectively applied onto a polyethylene terephthalate (PET) substrate including a primer layer formed thereon, and were then dried at 150°C, and then the peel strengths thereof were measured. The results thereof are given in Table 4 below.

**[Table 4]**

| | Comp. Ex. 1 | Ex. 1 | Ex. 2 | Ex. 5 |
|---|---|---|---|---|
| PVDF copolymer (%) | 75 | 75 | 75 | 75 |
| PMMA(%) | 25 | 25 | 25 | 25 |
| DMF:MEK | 3:1 | 3:1 | 3:1 | 3:1 |
| S/C(%) | 20 | 23 | 23 | 22 |
| Viscosity (cps) | - | 924 | 32633 | 600 |
| Dry Temp (°C) | 150 | 150 | 150 | 150 |
| Dry time (min) | 10 | 10 | 10 | 10 |
| Thickness(µm) | 24 | 30 | 36 | 50 |
| Peel strength (180°) | 0.107 | 0.521 | 0.428 | 0.255 |

Referring to Table 4, it can be ascertained that the copolymers of Examples 1 and 2 exhibited excellent peel strength (adhesive force) compared to the homopolymer of Comparative Example 1 even at a low drying temperature of 150°C.

### Test Example 4

Coating solutions, each of which was prepared by mixing the PVDF copolymer of Example 1 with an additive (PMMA) in various mixing ratios and then dissolving the mixture in a mixed solvent (DMF:MEK = 3:1), were applied onto a polyethylene terephthalate (PET) substrate provided with a primer layer, and were then dried at 160 °C and 200 °C, and then the peel strengths thereof were measured. The results thereof are given in Table 5 below.

**[Table 5]**

| | | Ratio | Con. | Thickness | Dry temp. | Peel strength (kg/cm) |
|---|---|---|---|---|---|---|
| | | 10:0 | 25% | 31 | 200°C, 10min | 0.388 |
| | | 10:0 | 25% | 31 | 160°C, 30min | 0328 |
| Example 1 (PVDF copolymer) | PMMA (additive) | 9:1 | 25% | 31 | 200°C, 10min | 0.439 |
| | | 9:1 | 25% | 25 | 160°C, 30min | 0.357 |
| | | 8:2 | 25% | 29 | 200°C, 10min | 0.411 |
| | | 8:2 | 25% | 24 | 160°C, 30min | 0.408 |
| | | 7:3 | 25% | 30 | 200°C, 10min | 0.439 |
| | | 7:3 | 25% | 32 | 160°C, 30min | 0.429 |
| | | 6:4 | 25% | 30 | 200°C, 10min | 0.305 |
| | | 6:4 | 25% | 29 | 160°C, 30min | 0.300 |

Referring to Table 5, it can be ascertained that good peel strength (adhesive force) could be obtained even when the mixing ratio of the PVDF copolymer of Example 1 and PMMA (additive) was changed.

### Test Example 5

A coating solution, which was prepared by dissolving the PVDF copolymer of Example 1 and an additive (PMMA) in a mixed solvent (DMF:MEK = 3:1), was applied onto a polyethylene terephthalate (PET) substrate provided with a primer layer, and was then dried at 160°C, and then the peel strengths thereof were measured. The results thereof are given in Table 6 below.

**[Table 6]**

| | | Ratio | Con. (%) | Thickness | Drying condition | Peel strength (kg/cm) |
|---|---|---|---|---|---|---|
| Example 1 (PVDF copolymer) and DMF (solvent) | PMMA (additive) and MEK (solvent) | 8:2 | 25 | 24 | 160°C, 10min | 0.441 |
| | | | | 23 | 160°C, 7min | 0.452 |
| | | | | 26 | 160°C, 50min | 0.436 |
| | | | | 27 | 160°C, 3min | 0.454 |
| | | | | 27 | 160°C, 1min | 0.513 |

Referring to Table 6, it can be ascertained that good peel strength (adhesive force) could be obtained even when the drying time was changed.

### Test Example 6

A coating solution, which was prepared by dissolving the PVDF copolymer of Example 2 and an additive (PMMA) in a mixed solvent (DMF:MEK = 3:1), was applied onto a polyethylene terephthalate (PET) substrate provided with a primer layer, and was then dried at 150°C or higher, and then the peel strengths thereof were measured. The results thereof are given in Table 7 below.

**[Table 7]**

| | | Ratio | Dry temp. | Peel strength (kg/cm) |
|---|---|---|---|---|
| Example 2 (PVDF copolymer) | PMMA (additive) | 7:3 | 150°C, 10min | 0.428 |
| | | 7:3 | 160°C, 10min | 0.398 |
| | | 7:3 | 200°C, 10min | 0.318 |

Referring to Table 7, it can be ascertained that good peel strength (adhesive force) could be obtained even when the drying temperature was changed.

### Test Example 7

Coating solutions, each of which was prepared by dissolving each of the PVDF copolymers of Example 2 and 3 and an additive (PMMA) in a mixed solvent (DMF:MEK = 3:1), were applied onto a polyethylene terephtalate (PET) substrate provided with a primer layer, and were then dried at 160°C and 130°C, and then the peel strengths thereof were measured The results thereof are given in Table 8 below.

**[Table 8]**

| | | Ratio | Dry temp. | Peel strength (kg/cm) |
|---|---|---|---|---|
| Examples 2 (PVDF copolymer) | | 8:2 | 160°C, 10min | 0.455 |
| | PMMA (additive) | 8:2 | 160°C, 4min | 0.422 |
| | | 8:2 | 130°C, 4min | 0.575 |
| Example 3 (PVDF copolymer) | | 8:2 | 160°C, 10min | 0.453 |
| | | 82 | 160°C, 4min | 0.530 |
| | | 8:2 | 130°C, 4min | 0.558 |

Referring to Table 8, it can be ascertained that good peel strength (adhesive force) could be obtained even at low drying temperatures of 160°C and 130°C.

### Test Example 8

A coating solution, which was prepared by dissolving the PVDF copolymer of Example 2 and an additive (PMMA) in an acetone solvent having a low boiling point, was applied onto a polyethylene terephthalate (PET) substrate provided thereon with a primer layer, and was then dried at 160°C or lower, and then the peel strengths thereof were measured. The results whereof are given in Table 9 below.

**[Table 9]**

| | | Ratio | Dry temp. | Peel strength (kg/cm) |
|---|---|---|---|---|
| Example 2 (PVDF copolymer) | PMMA (additive) | 8:2 | 160°C, 10min | 0.576 |
| | | 8:2 | 160°C, 5min | 0.452 |
| | | 8:2 | 150°C, 5min | 0.453 |
| | | 82 | 140°C, 5min | 0.384 |
| | | 8:2 | 130°C, 5min | 0.526 |

Referring to Table 9, it can be ascertained that good peel strength (adhesive force) could be obtained even at low drying temperatures because an acetone solvent having a low boiling point was used.

### Test Example 9

A coating solution, which was prepared by dissolving the PVDF copolymer of Example 2, an additive (PMMA) and a titanium dioxide (TiO₂) filler in a mixed solvent (DMF:MEK = 3:1), was applied onto a polyethylene terephthalate (PET) substrate provided thereon with a primer layer, and was then dried at 160°C and 220°C, and then the peel strengths thereof were measured. The results thereof are given in Table 10 below.

**[Table 10]**

| | | Filler | Ratio | Dry temp. | Peel strength (kg/cm) |
|---|---|---|---|---|---|
| Example 2 (PVDF copolymer) | PMMA (additive) | TiO₂ 10wt% | 3:1 | 160°C, 10min | 0.384 |
| | | | 3:1 | 220°C, 10min | tearing |

Referring to Table 10, it can be ascertained that, when the PVDF copolymer of Example 2 was used together with a filler, tearing occurred at 220°C, but good peel strength (adhesive force) could be obtained at a drying temperature of 160°C because an acetone solvent having a low boiling point was used.

## Claims

1. A solar cell back sheet, comprising:
a substrate layer; and
a resin layer that has been formed on at least one side of the substrate layer,
wherein the resin layer includes a polyvinylidene fluoride (PVDF)-based polymer, which is polymerized polyvinylidene fluoride (PVDF) with a comonomer,
a content of the comonomer is 5 to 50 wt%, relative to total weight of the polyvinylidene fluoride (PVDF)-based polymer,
the polyvinylidene fluoride (PVDF)-based polymer has a crystallinity of 10 to 40%, wherein the crystallinity is determined by differential scanning calorimetry from the heat of fusion of the polyvinylidene fluoride (PVDF)-based polymer, and the heat of fusion is measured when the polyvinylidene fluoride (PVDF)-based polymer is specondarily heated with heating rate of 10 K/min.

2. The solar cell back sheet according to claim 1, wherein the comonomer is selected from the group consisting of hexafluoropropylene (HFP), chlorotrifluoroethylene (CTFE), tetrafluoroethylene (TFE), trifluoroethylene, hexafluoroisobutylene, perfluorobutyl ethylene, perfluoropropylvinyl ether (PPVE), perfluoroethylvinyl ether (PEVE), perfluoromethylvinyl ether (PMVE), perfluoro-2,2-dimethyl-1,3-dioxolan (PDD), and perfluoro-2-methylene-4-methyl-1,3-dioxolan (PMD).

3. The solar cell back sheet according to claim 1, wherein the resin layer further includes an acrylic polymer comprising at least one selected from the group consisting of methylmethacrylate (MMA), glycidylmethacrylate (GMA), hydroxyethylmethacrylate (HEMA) and cyclohexylmaleimide (CHMI), polymethylmethacrylate (PMMA), a copolymer of methylmethacrylate and glycidylmethacrylate (MMA-GMA), a ternary copolymer of methylmethacrylate, glycidylmethacrylate and hydroxyethylmethacrylate (MMA-GMA-HEMA), a copolymer of methylmethacrylate and cyclohexylmaleimide (MMA-CHMI), a copolymer of methylmethacrylate and hydroxyethylmethacrylate (MMA-HEMA), a copolymer of methylmethacrylate and acylic acid (MMA-AA), and a copolymer of methylmethacrylate and methacylic acid (MMA-MAA).

4. The solar cell back sheet according to any one of claims 1 to 3, wherein the content of the comonomer is 10 to 30 wt%.

5. The solar cell back sheet according to any one of claims 1 to 3, wherein the solar cell back sheet comprises the resin layer which has been coated on the substrate layer with a solution containing the polyvinylidene fluoride (PVDF)-based polymer.

6. The solar cell back sheet according to any one of claims 1 to 3, wherein the resin layer further includes at least one of a pigment and a filler.

7. The solar cell back sheet according to any one of claims 1 to 3, wherein the resin layer has been dried at a temperature of 250°C or lower.

8. The solar cell back sheet according to claim 7, wherein the resin layer has been dried at a temperature of 100°C to 180°C.

9. The solar cell back sheet according to any one of claims 1 to 3, wherein the substrate layer is a metal layer or a resin layer.

10. The solar cell back sheet according to claim 9, wherein the resin layer is a polyester-based resin layer.

11. The solar cell back sheet according to any one of claims 1 to 3, wherein the resin layer has a thickness of 5 to 100 micrometers.

12. The solar cell back sheet according to any one of claims 1 to 3, wherein the solar cell back sheet further comprises a primer layer between the substrate layer and the resin layer.

13. The solar cell back sheet according to any one of claims 1 to 3, wherein the substrate layer is provided with the resin layer on one side thereof, and is provided with an adhesive layer and an insulation layer on the other side thereof.

14. The solar cell back sheet according to claim 13, wherein the insulation layer is an ethylene vinyl acetate (EVA) layer.

15. A method of manufacturing the solar cell back sheet of any one of claims 1 to 3, comprising:
providing a substrate layer;
dissolving a resin material containing a polyvinylidene fluoride (PVDF)-based polymer, which is polymerized polyvinylidene fluoride (PVDF) with a comonomer, in a solvent having a boiling point of 200°C or lower to prepare a coating solution; and
applying the coating solution onto at least one side of the substrate layer and then drying the applied coating solution at a temperature of 250°C or lower to form a resin layer,
a content of the comonomer is 5 to 50 wt%, relative to total weight of the polyvinylidene fluoride (PVDF)-based polymer,
the polyvinylidene fluoride (PVDF)-based polymer has a crystallinity of 10 to 40%, wherein the crystallinity is determined by differential scanning calorimetry from the heat of fusion of the polyvinylidene fluoride (PVDF)-based polymer, and the heat of fusion is measured when the polyvinylidene fluoride (PVDF)-based polymer is secondarily heated with heating rate of 10 K/min.

16. The method of manufacturing the solar cell back sheet according to claim 15, further comprising:
forming a primer layer before forming the resin layer on the substrate layer.

17. The method of manufacturing the solar cell back sheet according to claim 15, further comprising:
forming sequentially an adhesive layer and an insulation layer on the other side of the substrate layer when the resin layer is formed on only one side of the substrate layer.

18. A solar cell, comprising the solar cell back sheet of any one of claims 1 to 3.

## Patentansprüche

1. Rückseitige Folie für eine Solarzelle, welche umfasst:
eine Substratschicht; und
eine Harzschicht, die auf wenigstens einer Seite der Substratschicht gebildet worden ist,
wobei die Harzschicht ein Polymer auf Basis von Polyvinylidenfluorid (PVDF) einschließt, das mit einem Comonomer polymerisiertes Polyvinylidenfluorid (PVDF) ist, wobei ein Gehalt des Comonomers 5-50 Gew.-% relativ zum Gesamtgewicht des Polymers auf Basis von Polyvinylidenfluorid (PVDF) ist,
wobei das Polymer auf Basis von Polyvinylidenfluorid (PVDF) eine Kristallinität von 10-40% aufweiset, wobei die Kristallinität durch Differentialscanningkalorimetrie aus der Schmelzwärme des Polymers auf Basis von Polyvinylidenfluorid (PVDF) bestimmt wird, und wobei die Schmelzwärme gemessen wird, wenn das Polymer auf Basis von Polyvinylidenfluorid (PVDF) zum zweiten Mal mit einer Aufheizgeschwindigkeit von 10 K/Minute erwärmt wird.

2. Rückseitige Folie für eine Solarzelle nach Anspruch 1, wobei das Comonomer ausgewählt ist aus der Gruppe bestehend aus Hexafluorpropylen (HFP), Chlortrifluorethylen (CTFE), Tetrafluorethylen (TFE), Trifluorethylen, Hexafluorisobutylen, Perfluorbutylethylen, Perfluorpropylvinylether (PPVE), Perfluorethylvinylether (PEVE), Perfluormethylvinylether (PMVE), Perfluor-2,2-dimethyl-1,3-dioxolan (PDD) und Perfluor-2-methylen-4-methyl-1,3-dioxolan (PMD).

3. Rückseitige Folie für eine Solarzelle nach Anspruch 1, wobei die Harzschicht ferner ein Acrylpolymer einschließt, das wenigstens eines umfasst, das ausgewählt ist aus der Gruppe bestehend aus Methylmethacrylat (MMA), Glycidylmethacrylat (GMA), Hydroxyethylmethacrylat (HEMA) und Cyclohexylmaleimid (CHMI), Polymethylmethacrylat (PMMA), einem Copolymer aus Methylmethacrylat und Glycidylmethacrylat (MMA-GMA), einem ternären Copolymer aus Methylmethacrylat, Glycidylmethacrylat und Hydroxyethylmethacrylat (MMA-GMA-HEMA), einem Copolymer aus Methylmethacrylat und Cyclohexylmaleimid (MMA-CHMI), einem Copolymer aus Methylmethacrylat und Hydroxyethylmethacrylat (MMA-HEMA), einem Copolymer aus Methylmethacrylat und Acrylsäure (MMA-AA) und einem Copolymer aus Methylmethacrylat und Methacrylsäure (MMA-MAA).

4. Rückseitige Folie für eine Solarzelle nach einem der Ansprüche 1 bis 3, wobei der Gehalt des Comonomers 10-30 Gew.-% ist.

5. Rückseitige Folie für eine Solarzelle nach einem der Ansprüche 1 bis 3, wobei die rückseitige Folie für die Solarzelle die Harzschicht umfasst, die auf der Substratschicht mit einer Lösung enthaltend das Polymer auf Basis von Polyvinylidenfluorid (PVDF) beschichtet worden ist.

6. Rückseitige Folie für eine Solarzelle nach einem der Ansprüche 1 bis 3, wobei die Harzschicht ferner wenigstens eines eines Pigments und eines Füllstoffs einschließt.

7. Rückseitige Folie für eine Solarzelle nach einem der Ansprüche 1 bis 3, wobei die Harzschicht bei einer Temperatur von 250°C oder niedriger getrocknet worden ist.

8. Rückseitige Folie für eine Solarzelle nach Anspruch 7, wobei die Harzschicht bei einer Temperatur von 100°C bis 180°C getrocknet worden ist.

9. Rückseitige Folie für eine Solarzelle nach einem der Ansprüche 1 bis 3, wobei die Substratschicht eine Metallschicht oder eine Harzschicht ist.

10. Rückseitige Folie für eine Solarzelle nach Anspruch 9, wobei die Harzschicht eine Harzschicht auf Basis von Polyester ist.

11. Rückseitige Folie für eine Solarzelle nach einem der Ansprüche 1 bis 3, wobei die Harzschicht eine Dicke von 5-100 µm aufweist.

12. Rückseitige Folie für eine Solarzelle nach einem der Ansprüche 1 bis 3, wobei die rückseitige Folie für die Solarzelle ferner eine Primerschicht zwischen der Substratschicht und der Harzschicht umfasst.

13. Rückseitige Folie für eine Solarzelle nach einem der Ansprüche 1 bis 3, wobei die Substratschicht mit der Harzschicht auf einer Seite derselben bereitgestellt ist und mit einer Klebstoffschicht und einer Isolationsschicht auf der anderen Seite derselben bereitgestellt ist.

14. Rückseitige Folie für eine Solarzelle nach Anspruch 13, wobei die Isolationsschicht eine Ethylenvinylacetatschicht (EVA) ist.

15. Verfahren zum Herstellen der rückseitigen Folie für eine Solarzelle nach einem der Ansprüche 1 bis 3, welches umfasst:
Bereitstellen einer Substratschicht;
Auflösen eines Harzmaterials enthaltend ein Polymer auf Basis von Polyvinylidenfluorid (PVDF), welches mit einem Comonomer polymerisiertes Polyvinylidenfluorid (PVDF) ist, in einem Lösungsmittel mit einem Siedepuntk von 200°C oder niedriger, um eine Beschichtungslösung herzustellen; und
Auftragen der Beschichtungslösung auf wenigstens eine Seite der Substratschicht und dann Trocknen der aufgetragenen Beschichtungsschicht bei einer Temperatur von 250°C oder niedriger, um eine Harzschicht zu bilden,
wobei ein Gehalt des Comonomers 5-50 Gew.-% relativ zum Gesamtgewicht des Polymers auf Basis von Polyvinylidenfluorid (PVDF) ist,
das Polymer auf Basis von Polyvinylidenfluorid (PVDF) eine Kristallinität von 10 bis 40% aufweist, wobei die Kristallinität bestimmt wird durch Differentialscanningkalorimetrie aus der Schmelzwärme des Polymers auf Basis von Polyvinylidenfluorid (PVDF), wobei die Schmelzwärme gemessen wird, wenn das Polymer auf Basis von Polyvinylidenfluorid zum zweiten Mal mit einer Aufheizgeschwindigkeit von 10 K/Minute erwärmt wird.

16. Verfahren zum Herstellen der rückseitigen Folie für eine Solarzelle nach Anspruch 15, weiter umfassend:
Bilden einer Primerschicht vor dem Bilden der Harzschicht auf der Substratschicht.

17. Verfahren zum Herstellen der rückseitigen Folie für eine Solarzelle nach Anspruch 15, weiter umfassend:
sequentielles Bilden einer Klebstoffschicht und einer Isolationsschicht auf der anderen Seite der Substratschicht, wenn die Harzschicht lediglich auf einer Seite der Substratschicht gebildet ist.

18. Solarzelle, die die rückseitige Folie für eine Solarzelle nach einem der Ansprüche 1 bis 3 umfasst.

## Revendications

1. Feuille arrière pour cellule solaire comprenant :
une couche de substrat; et
une couche de résine qui a été formée sur au moins une face de la couche de substrat,
dans laquelle la couche de résine comprend un polymère à base de fluorure de polyvinylidène (PVDF),
qui est un fluorure de polyvinylidène (PVDF) polymérisé avec un comonomère,
une teneur en comonomère est de 5 à 50 % en poids, par rapport au poids total du polymère à base de fluorure de polyvinylidène (PVDF)
le polymère à base de fluorure de polyvinylidène (PVDF) ayant une cristallinité de 10 à 40%, la cristallinité étant déterminée par analyse calorimétrique différentielle à partir de la chaleur de fusion du polymère à base de fluorure de polyvinylidène (PVDF) et la chaleur de fusion étant mesurée lorsque le polymère à base de fluorure de polyvinylidène (PVDF) est secondairement chauffé à une vitesse de chauffe de 10 K/minute.

2. Feuille arrière pour cellule solaire selon la revendication 1, dans laquelle le comomomère est sélectionné dans le groupe constitué d'hexafluoropropylène (HFP), de chlorotrifluoroéthylène (CTFE), de tétrafluoroéthylène (TFE), de trifluoroéthylène, d'hexafluoroisobutylène, de perfluorobutyle-éthylène, de perfluoropropylvinyle-éther (PPVE), de perfluoroéthylvinyl-éther (PEVE), de perfluorométhylvinyl-éther (PMVE), de perfluoro-2,2-diméthyl-1,3-dioxalane (PDD) et de perfluoro-2-méthylène-4-méthyl-1,3-dioxolane (PMD).

3. Feuille arrière pour cellule solaire selon la revendication 1, dans laquelle la couche de résine comprend en outre un polymère acrylique comprenant au moins un composé sélectionné dans le groupe constitué de méthylméthacrylate (MMA), de glycidylméthacrylate (GMA), d'hydroxyéthylméthacrylate (HEMA) et de cyclohexylmaléimide (CHMI), de polyméthylméthacrylate (PMMA), d'un copolymère de méthylméthacrylate et de glycidylméthacrylate (MMA-GMA), d'un copolymère ternaire de méthylméthacrylate, de glycidylméthacrylate et d'hydroxyéthylméthacrylate (MMA-GMA-HEMA), d'un copolymère de méthylméthacrylate et de cyclohexylmaléimide (MMA-CHMI), d'un copolymère de méthylméthacrylate et d'hydroxyéthylméthacrylate (MMA-HEMA), d'un copolymère de méthylméthacrylate et d'acide acylique (MMA-AA) et d'un copolymère de méthylméthacrylate et d'acide méthacylique (MMA-MAA).

4. Feuille arrière pour cellule solaire selon l'une quelconque des revendications 1 à 3, dans laquelle la teneur en comonomère est de 10 à 30 % en poids.

5. Feuille arrière pour cellule solaire selon l'une quelconque des revendications 1 à 3, laquelle feuille arrière pour cellule solaire comprend la couche de résine qui a été revêtue sur la couche de substrat avec une solution contenant le polymère à base de fluorure de polyvinylidène (PVDF).

6. Feuille arrière pour cellule solaire selon l'une quelconque des revendications 1 à 3, dans laquelle la couche de résine comprend au moins un/une d'un pigment et d'une substance de remplissage.

7. Feuille arrière pour cellule solaire selon l'une quelconque des revendications 1 à 3, dans laquelle la couche de résine a été séchée à une température inférieure ou égale à 250 °C.

8. Feuille arrière pour cellule solaire selon la revendication 7, dans laquelle la couche de résine a été séchée à une température de 100 °C à 180 °C.

9. Feuille arrière pour cellule solaire selon l'une quelconque des revendications 1 à 3, dans laquelle la couche de substrat est une couche de métal ou une couche de résine.

10. Feuille arrière pour cellule solaire selon la revendication 9, dans laquelle la couche de résine est une couche de résine à base de polyester.

11. Feuille arrière pour cellule solaire selon quelconque l'une des revendications 1 à 3, dans laquelle la couche de résine a une épaisseur de 5 à 100 micromètres.

12. Feuille arrière pour cellule solaire selon l'une quelconque des revendications 1 à 3, laquelle feuille arrière pour cellule solaire comprend en outre une couche d'apprêt entre la couche de substrat et la couche de résine.

13. Feuille arrière pour cellule solaire selon l'une quelconque des revendications 1 à 3, dans laquelle la couche de substrat est pourvue de la couche de résine sur l'une de ses faces et d'une couche adhésive et d'une couche isolante sur l'autre face.

14. Feuille arrière pour cellule solaire selon la revendication 13, dans laquelle la couche isolante est une couche d'éthylène-acétate de vinyle (EVA).

15. Procédé de fabrication de la feuille arrière pour cellule solaire selon l'une quelconque des revendications 1 à 3, comprenant les étapes consistant à :
créer une couche de substrat ;
dissoudre une matière résinique contenant du polymère à base de fluorure de polyvinylidène (PVDF), qui est un fluorure de polyvidylène (PVDF) polymérisé avec un comonomère, dans un solvant ayant un point d'ébullition inférieur ou égal à 200 °C pour préparer une solution de revêtement ; et
appliquer la solution de revêtement à au moins une face de la couche de substrat et sécher ensuite la solution de revêtement appliquée à une température inférieure ou égale à 250 °C pour former une couche de résine,
une teneur en comonomère étant de 5 à 50 % en poids par rapport au poids total du polymère à base de fluorure de polyvinylidène (PVDF),
le polymère à base de fluorure de polyvinylidène (PVDF) ayant une cristallinité de 10 à 40 %, la cristallinité étant déterminée par analyse calorimétrique différentielle à partir de la chaleur de fusion du polymère à base de fluorure de polyvinylidène (PVDF) et la chaleur de fusion étant mesurée lorsque le polymère à base de fluorure de polyvinylidène (PVDF) est secondairement chauffé à une vitesse de chauffe de 10 K/minute.

16. Procédé de fabrication d'une feuille arrière pour cellule solaire selon la revendication 15, comprenant en outre l'étape consistant à :
former une couche d'apprêt avant de former la couche de résine sur la couche de substrat.

17. Procédé de fabrication d'une feuille arrière pour cellule solaire selon la revendication 15, comprenant l'étape consistant à :
former séquentiellement une couche adhésive et une couche isolante sur l'autre face de la couche de substrat lorsque la couche de résine est formée sur une face seulement de la couche de substrat.

18. Cellule solaire, comprenant la feuille arrière pour cellule solaire selon l'une quelconque des revendications 1 à 3.
